Europäisches Patentamt

European Patent Office

Office européen des brevets

(11) Publication number: **0 240 110**
A1

# EUROPEAN PATENT APPLICATION

(21) Application number: 87300952.6

(22) Date of filing: 03.02.87

(51) Int. Cl.³: **C 23 C 14/48**
C 22 C 16/00, C 23 F 11/00

(30) Priority: 03.02.86 US 825408

(43) Date of publication of application:
07.10.87 Bulletin 87/41

(84) Designated Contracting States:
BE DE FR GB IT SE

(71) Applicant: THE BABCOCK & WILCOX COMPANY
1010 Common Street P.O. Box 60035
New Orleans Louisiana 70160(US)

(72) Inventor: Baty, David Lee
318 Lake Forest Drive
Lynchburg VA 24502(US)

(72) Inventor: Young, William Crawford
Rte. Box 296 Chivas Drive
Roanoke VA 24019(US)

(72) Inventor: Lewis, David Evan
105 Ivy Lea Drive
Forest VA 24551(US)

(74) Representative: Cotter, Ivan John et al,
D. YOUNG & CO. 10 Staple Inn
London WC1V 7RD(GB)

(54) Improving corrosion resistance of zirconium alloys.

(57) A process for improving the corrosion resistance and reducing hydrogen absorption of zirconium alloys to be used, for example, in a light water nuclear reactor environment, comprises implanting the alloy surface with chromium ions. Implantation is conducted at an incident ion energy of about 75 keV and a dose of about $7.0 \times 10^{16}$ ions/cm$^2$ to $1.4 \times 10^{17}$ ions/cm$^2$ until an approximate chromium surface concentration of 2 to 40 atomic percent is achieved.

EP 0 240 110 A1

## IMPROVING CORROSION RESISTANCE
## OF ZIRCONIUM ALLOYS

This invention relates to processes for improving the corrosion resistance of zirconium alloys (such as, for instance, Zircaloy), which alloys may, for example, be used in light water nuclear reactor environments.

Zirconium alloys have been extensively used in nuclear reactor systems due to their optimal low neutron cross-section (low tendency to capture neutrons), generally good corrosion resistance in water and steam, and adequate strength for cladding uranium oxide fuel used in light water reactors.

Future reactor designs and utilizations are placing more emphasis on ensuring adequate corrosion resistance. Improvements in the corrosion resistance of the zirconium alloy Zircaloy-4, for example, while retaining the benefits of its other favourable properties, is a highly desirable goal for advanced applications.

Zircaloy-4 is an alloy composed principally of zirconium (Zr) but also containing, on a weight percent basis, 1.20 to 1.70 % tin, 0.18 to 0.24% iron and 0.07 to 0.13% chromium.

The corrosion of Zircaloy-4 in water or steam occurs by the growth of a zirconium oxide layer produced by the reaction $Zr + 2H_2O \rightarrow ZrO_2 + 2H_2$. The growth of this layer occurs initially by either cubic or parabolic oxidation kinetics, but after a certain weight gain, the kinetics of growth are linear. The oxide film in general is quite adherent well out into the linear kinetics region. However, at a certain oxide thickness, the oxide adherency is seriously impaired and spalling or "breakaway" occurs. In nearly all present applications, the breakaway region is not reached.

During the corrosion reaction, however, hydrogen is produced. Part of this hydrogen is absorbed by the Zircaloy-4 metal while the balance is carried off in the water or steam coolant. Hydrogen absorbed by the Zircaloy-4 will eventually reach sufficient concentrations so that zirconium hydrides will form in the Zircaloy-4. The hydride formations can lead to degraded ductility and fracture toughness in the Zircaloy-4 at lower service temperature.

Improvements in the corrosion resistance can therefore occur by lowering the rate of corrosion, by eliminating the change to linear kinetics, by extending the time to film breakaway and by reducing the pick-up fraction for hydrogen in Zircaloy-4. Alloy modifications have been looked at from time to time, but the generally good corrosion behaviour and adequate strength of Zircaloy-2, Zircaloy-4, Zr-1Nb, Zr-2.5Nb and Ozhennite (Zr-Sn-Nb-Fe-Ni) have tended to limit any further development of commercial reactor grade alloys. However, current concerns over nodular corrosion in boiling water reactors (BWRs) and over the variable corrosion resistance at extended burnup in both BWRs and pressurized water reactors (PWRs) generated a need to look at ways to improve existing alloy grades through modified thermomechanical processing and possibly alloy changes. Alloy modifications and thermo-mechanical treatments, attempted over the years to improve the corrosion resistance of Zircaloy-4 and other zirconium alloys, in general, alter either the chemistry or the structure of the entire material section, or both. This can lead to variability in the effectiveness throughout the material and alter the other properties of the alloy in an undesirable manner.

Ion implantation is generally known as an effective technique for preparing surface alloys of controlled composition without affecting the underlying bulk structure and properties of the metal. Ion implantation is the process by which sufficiently energetic ions are propelled into the surface of a host material (metal, ceramic or plastics), sometimes referred to as a matrix, such that penetration beyond surface layers occurs. This is achieved by accelerating an ion species to energies between 3 to 500 keV with resulting target penetrations to depths of 100 to 10,000 angstroms below the surface. The ion species is accelerated in vacuum through an appropriate electric potential and electromagnetically aligned and collimated to strike the material target. At low energies, the ions essentially plate onto the material target and can subsequently be distributed into the target material through an inert ion (such as xenon) bombardment. At high energies, the ion species are driven into the target material creating a distribution or mixing of the implant ion with the target material.

Use of ion implantation for surface modification of surface sensitive properties of materials by changing the mechanical and chemical behaviour of the surface layers is now the subject of growing research and application. Numerous surface properties of materials are influenced by surface composition. Such properties include friction, wear, hardness, fatigue, corrosion, resistance, electrochemistry, catalysis, decorative finish, bonding, lubrication, adhesion and reflectance. Hence, ion implantation holds promise as a technique for altering such surface properties.

Ion implantation thus offers a method for bringing about novel surface alloy changes without altering the acceptable bulk mechanical properties of the existing zirconium alloys. Because of the potential for non-equilibrium phase structure, alloy conditions can be created which have never been evaluated before due to the nearer chemical equilibrium imposed by traditional high temperature metal processing of zirconium alloys.

Alloy development work performed on zirconium during the 1960's showed that a Zr-1.2%Cr - .08%Fe alloy (Valloy) when properly processed produced an alloy superior to the Zircaloy-2 in $400^{\circ}$C and $500^{\circ}$C steam and equivalent behavior in $300^{\circ}$C steam. Critical to this improved performance is the necessity to retain 0.7% (0.4%) Cr in solution and to have an intermetallic particle size much less than 1 micrometre in size. These requirements are achieved by quenching from the beta phase and a specific fabrication schedule. Lot to lot variability in corrosion behaviour has reportedly been the main reason for lack of commercial acceptance of this alloy.

In accordance with the present invention, a process of ion implantation is used to add chromium elements to Zircaloy-4 or other zirconium based alloys to alter the surface composition and the crystalline structure of the alloy's surface.

According to one aspect of the invention there is provided a process for improving the corrosion resistance and reducing hydrogen absorption of a zirconium alloy, the process comprising implanting chromium ions into the surface of the zirconium alloy at an incident ion energy of about 75 keV and a dose of about $7.0 \times 10^{16}$ ions/cm$^2$ to $1.4 \times 10^{17}$ ions/cm$^2$ until an approximate chromium surface concentration of 2 to 40 atomic percent is achieved.

According to another aspect of the invention there is provided a process in which chromium ions are directly implanted into Zircaloy-4 to create a chromium concentration layer of less than 2000 angstroms deep. The desired surface concentrations are 2, 20 and 40 atomic percent. These are $1.4 \times 10^{17}$ Cr ions/cm$^2$. The Cr ion energy for implantation is 75 keV with a beam current of 1.2 mA. The implanted speciments were either tested in the as-implanted condition or given a 510$^{\circ}$C (950$^{\circ}$F) stress relief anneal for 2 hours.

Through the use of implantation of chromium, an improved corrosion resistant layer is imparted to the Zircaloy-4 and hydrogen absorption is reduced. Because of the shallowness of this modified layer, none of the bulk properties of the Zircaloy-4 will be altered. The nature of the alloying created by the ion implantation cannot be created by traditional melting, hot working and heat treatment.

The invention will now be further described, by way of illustrative and non-limiting example, with reference to the accompanying drawings, in which:

Figure 1 is a graph which schematically illustrates weight gain or growth of an oxidation layer of a Zircaloy-4 material as a function of time before and after a transition to linear growth;

Figures 2 to 4 graphically illustrate chromium concentration as a function of depth in Zircaloy-4 specimens which have been treated in accordance with processes embodying the invention; and

Figures 5 to 7 graphically illustrate corrosion weight gain of Zircaloy-4 materials which were and were not treated by processes embodying the invention.

The present invention will now be illustrated by reference to the following specific example, which is presented for the purpose of illustration only. The present invention is not intended to be limited thereto.

## EXAMPLE

The surfaces of specimens or coupons composed of a zirconium alloy (Zircaloy-4 wrought flat plate 28.575 mm X 22.225 mm X 4.7625 mm (1.125 inches X 0.875 inches X 0.1875 inches)) were directly bombarded with chromium ion doses of $7 \times 10^{15}$, $7 \times 10^{16}$, and $1/4 \times 10^{17}$ chromium ions/cm$^2$ at 75 keV, to obtain surface concentrations of 2, 20 and 40 atomic percent.

The flat specimens were mechanically mounted using set screws in specimen hanger holes on metal discs 101.6 mm (4 inches) in diameter which rotated under the specific ion beam. After the desired doses were achieved on one side, the specimens were removed and turned over to implant the opposite face of the specimens. Beam incidence was normal in these implants. The side edges of the specimens and the hole surfaces were not implanted since they were parallel to the implant beam. The implantation was performed in less than $10^{-6}$ torr Ar. The specimens could be viewed during implantation and a pale blue-violet glow emanated from the surfaces during implantation. Specimen heating occurs in an estimated temperature range of 93 to 204$^{\circ}$C (200 to 400$^{\circ}$F).

After implantation, a number of specimens were subjected to vacuum stress relief annealing at 510$^{\circ}$C (950$^{\circ}$F) for two hours. Half the specimens for each implant condition were tested as implanted, the other half were tested after being stress-relief annealed. Several specimens were not implanted but kept as control specimens. Half of the unimplanted control specimens were also given the stress relief anneal treatment at the same time with the selected implant specimens.

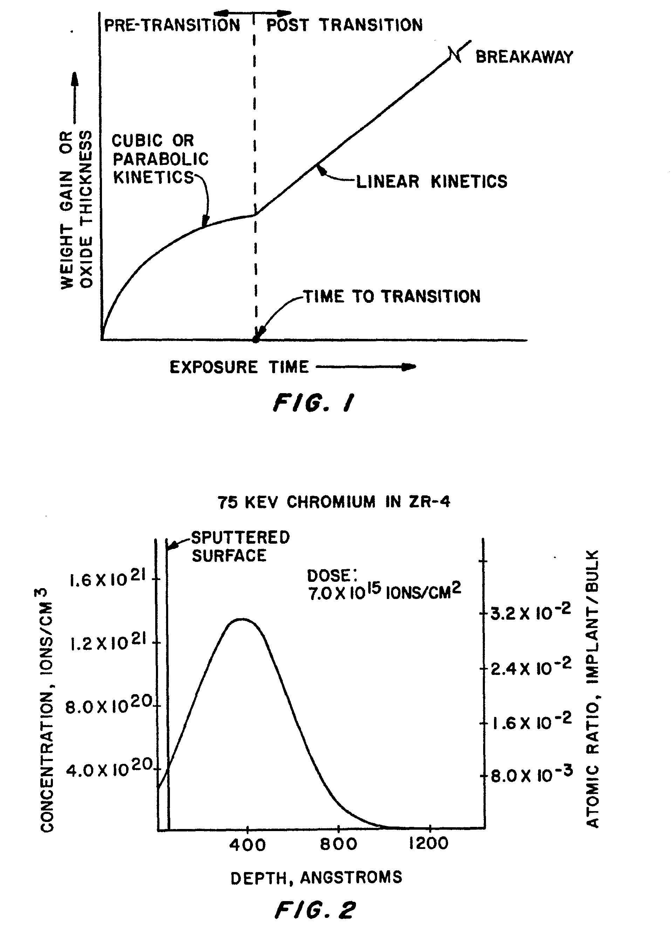

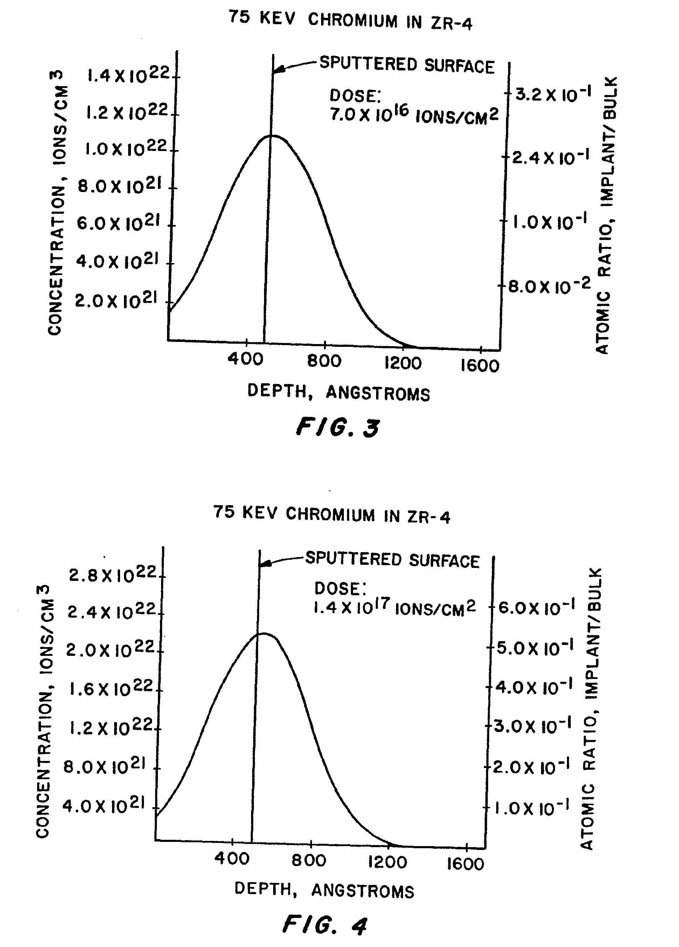

The calculated ion distributions as a function of depth from the surface are shown in Figures 2, 3 and 4. It will be understood that, as used in Figures 2 to 4, the term "sputtered surface" is used to refer to the final surface created by sputtering Zr and Cr atoms from the surface by Cr ions during implantation. At a chromium dose of $7 \times 10^{15}$, the calculated

surface concentration is about 1% with a maximum concentration of about 3% at 400 angstroms. The total depth of chromium penetration was approximately 1,000 angstroms. At doses of $7 \times 10^{16}$ and $1.4 \times 10^{17}$, the estimated surface concentration was 24% and 50%, respectively. The as-sputtered surface had the maximum concentration in the distribution. The depth of chromium penetration was estimated to be 1,300 angstroms in both the intermediate and high chromium doses.

Colour changes in some of the surfaces of chromium implanted surfaces were observed. At the low chromium dose of $7 \times 10^{15}$ no discolouration was observed. After $7 \times 10^{16}$, however, colours ranging from dark gold, purple, dark blue, steel gray and straw were observed. At $1.4 \times 10^{17}$ ion/cm$^2$, specimens which previously had gold, purple, and blue variations on their surface became uniformly gold in colour. The subsequent two hour, $510^{\circ}$C ($950^{\circ}$F) vacuum stress relief on half of the specimens eliminated any trace of colouration.

Weights and dimensions of the specimens were measured before and after implantation. The post-implantation dimensions were used for subsequent weight gain per unit surface area measurement calculations.

Corrosion effects were determined by the technique of weight gain determination. Corrosion testing of the implanted and control specimens was performed in $399^{\circ} \pm 2.78^{\circ}$C ($750^{\circ} \pm 5^{\circ}$F) steam at $10.34 \pm 0.69$MPa ($1500 \pm 100$ lbf/in$^2$). The specimens were reweighed and alcohol cleaned prior to the start of testing. The mass of each specimen is known within $\pm 0.05$ mg, which, when combined with the surface area measurement accuracy, allows the weight gain to be determined within $\pm 0.25$ mg/dm$^2$. The specimens were periodically reweighed. Weight gains per dm$^2$ were based on untested surface area dimensions.

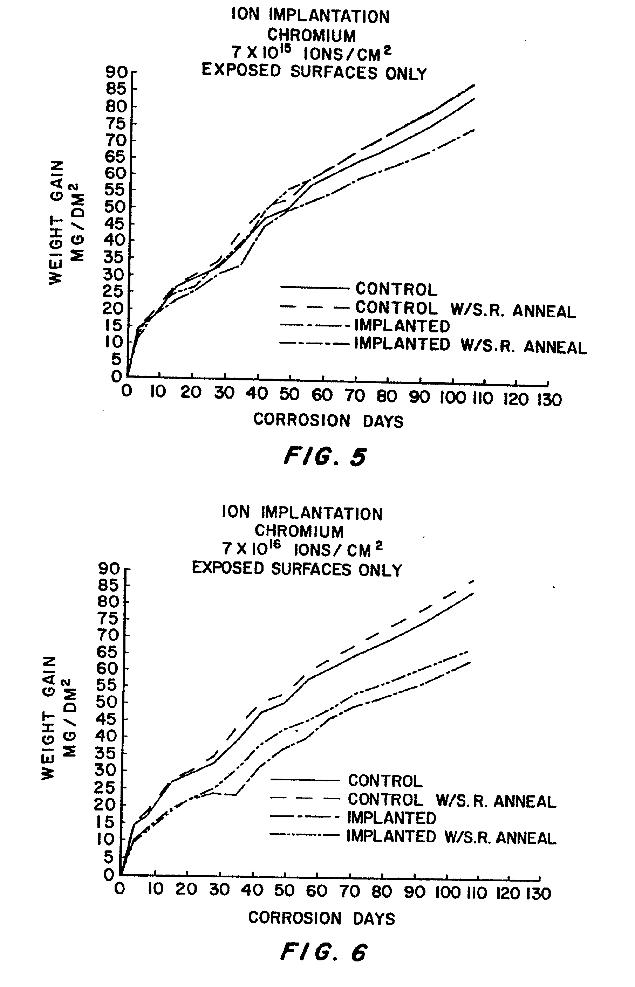

The testing schedule was designed to provide sufficient data points in the early cubic kinetics region out to about 30 to 35 days behaviour as well as to provide key comparisons with normal Zircaloy-4 behaviour at 3, 7, and 14 days. The "normal" corrosion behaviour in the cubic or pre-transition range, as shown by Figure 1, was modelled. The transition from cubic to linear kinetics occurs at a weight gain of approximately 33 mg/dm$^2$ which takes about 36 days to reach in $399^{\circ}$C ($750^{\circ}$C) steam for normal Zircaloy-4. The specific weight gains for each specimen were determined as a function of exposure time and are illustrated by Figures 5, 6 and 7.

Figures 5, 6 and 7 show specific weight gains as a function of exposure time for the three dose levels of chromium. The control specimen data is plotted with the implanted specimens on each graph.

For each of Figures 5, 6 and 7, actual weight gain values of the implanted specimens are adjusted by assuming areas not implanted to have the same weight gain as the appropriate control.

Figure 6 shows that for pre-transition corrosion (i.e. less than 36 days) the specimens implanted with a dose of $7 \times 10^{16}$ chromium ions/cm$^2$ have the lowest weight gains of any tested. The as-implanted specimens at this dose exhibit the least specific weight gain of 23.30 mg/dm$^2$ at 33.95 days of exposure compared to 39.45 mg/dm$^2$ for the as-received control coupons. The stress relief annealed chromium implanted specimens at this dose had 31.20 mg/dm$^2$ weight gain compared to 43.77 mg/dm$^2$ for the stress relief annealed control coupons.

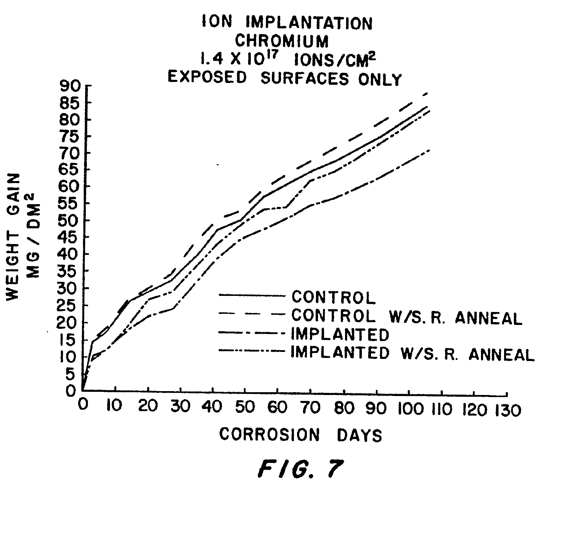

Specimens with a $1.4 \times 10^{17}$ chromium ions/cm$^2$ dose also show some reduction in specific weight gain compared to the control specimens in Figure 7. Again, the as-implanted specimens show somewhat lower weight gains of 31.60 mg/dm$^2$ than their stress-relief annealed counterparts which had 36.3 mg/dm$^2$.

At a dose of $7 \times 10^{15}$ Cr ions/cm$^2$, the implanted specimens showed a marginal reduction in weight gain in Figure 5 compared to the control specimens. The as-implanted specimens were at 33.65 mg/dm$^2$ compared to the 39.45 mg/dm$^2$ for the as-received control specimens. The stress relieved counterparts were similar to the control specimen behaviour with 39.20 mg/dm$^2$ compared to 43.77 mg/dm$^2$ for the stress relieved control specimens.

In the post-transition linear kinetics region, the chromium implanted specimens generally showed continued lower weight gains compared to the control specimens. This occurs not only because of the lower weight gain coming off the pretransition region, but also because the slope or rate of weight gain for the chromium implanted specimens in post-transition is smaller. Specimens with a $7 \times 10^{16}$ chromium ion/cm$^2$ dose continue to show the lowest weight gains, followed by the as-implanted $7 \times 10^{15}$ and $1.4 \times 10^{17}$ chromium ions/cm$^2$ dose specimens. At $7 \times 10^{16}$ chromium ions/cm$^2$ the slope, or corrosion rate, is 0.49 (mg/dm$^2$)/day for the as-implanted specimens and 0.46 (mg/dm$^2$)/day for the stress relieved specimens. This compares to 0.58 and 0.61 $(mg/dm^2)$/day for the as-received and stress relieved control specimens, respectively. Rates of 0.46 and 0.48 $(mg/dm^2)$/day were measured for the as-implanted specimens at $7 \times 10^{15}$ and $1.4 \times 10^{17}$ chromium ions/$cm^2$, respectively. The stress relieved specimens at $7 \times 10^{15}$ and $1.4 \times 10^{17}$ chromium ions/$cm^2$ show no improvement over the controls.

The hydrogen content of the chromium implant specimens was lower on the average than the control specimens. As shown in the Table appearing hereinbelow, after 105 days the chromium implanted specimens had an average of $27.0 \pm 6.1$ ppm hydrogen as compared to an average of $38.0 \pm 5.0$ ppm hydrogen for the control specimens. To normalize out the effect of different amounts of corrosion or weight gain, the ratio of hydrogen content to weight gain was taken. The chromium implant specimens have a lower pick-up of hydrogen per unit weight gain than the control specimens. The specimens implanted with chromium had an average $0.267 \pm 0.062$ ppm hydrogen per unit weight gain compared to $0.353 \pm 0.066$ ppm hydrogen per unit weight gain for the control specimens.

In summary, the best performing chromium implant in pre-transition was the as-implanted $7 \times 10^{16}$ ion/$cm^2$ dose specimen which had a 41% lower weight gain than the as-received control specimens. In post-transition, reductions in corrosion rate of 16% to 25% were achieved over the various combinations of ion dose and anneal. Only the stress relieved specimens at $7 \times 10^{15}$ and $1.4 \times 10^{17}$ ions/$cm^2$ showed no reduction in corrosion rate. As a group, the chromium implants showed a 24% reduction in hydrogen pickup per unit weight gain.

10

TABLE

Hydrogen Content After 105 Days

| Specimen Number | Ion | Dose, ions/cm$^2$ | Condition | Hydrogen Content ppm | Hydrogen Pick-up/ Specific Weight Gain, ppm H/(mg/dm$^2$) |
|---|---|---|---|---|---|
| 1 | Cr | 7 x 10$^{15}$ | As-implanted | 27 | 0.28 |
| 2 | Cr | 7 x 10$^{15}$ | Stress relieved | 29 | 0.24 |
| 3 | Cr | 7 x 10$^{16}$ | As-implanted | 23 | 0.25 |
| 4 | Cr | 7 x 10$^{16}$ | Stress relieved | 18 | 0.17 |
| 5 | Cr | 1.4 x 10$^{17}$ | As-implanted | 29 | 0.31 |
| 6 | Cr | 1.4 x 10$^{17}$ | Stress relieved | 36 | 0.35 |
| | | | Average Value | 27.0 ± 6.1 | 0.267 ± 0.062 |
| 7 | Control | None | As-received | 43 | 0.44 |
| 8 | Control | None | As-received | 35 | 0.32 |
| 9 | Control | None | As-received | 36 | 0.34 |
| 10 | Control | None | Stress relieved | 45 | 0.43 |
| 11 | Control | None | Stress relieved | 37 | 0.31 |
| 12 | Control | None | Stress relieved | 32 | 0.28 |
| | | | Average Value | 37.0 ± 5.0 | 0.353 ± 0.066 |

## CLAIMS

1. A process for improving the corrosion resistance and reducing hydrogen absorption of a zirconium alloy, the process comprising implanting chromium ions into the surface of the zirconium alloy at an incident ion energy of about 75 keV and a dose of about $7.0 \times 10^{16}$ ions/cm$^2$ to $1.4 \times 10^{17}$ ions/cm$^2$ until an approximate chromium surface concentration of 2 to 40 atomic percent is achieved.

2. A process according to claim 1, comprising annealing the implanted zirconium alloy.

3. A process according to claim 1 or claim 2, wherein the alloy is Zircaloy-4.

*FIG. 1*

*FIG. 2*

0240110

2 / 4

**75 KEV CHROMIUM IN ZR-4**

FIG. 3

**75 KEV CHROMIUM IN ZR-4**

FIG. 4

( ,

ION IMPLANTATION
CHROMIUM
$7 \times 10^{15}$ IONS/CM$^2$
EXPOSED SURFACES ONLY

CONTROL
— — — CONTROL W/S.R. ANNEAL
—·—·— IMPLANTED
—··—··— IMPLANTED W/S.R. ANNEAL

(y-axis) WEIGHT GAIN MG/DM$^2$
(x-axis) CORROSION DAYS

**F/G. 5**

ION IMPLANTATION
CHROMIUM
$7 \times 10^{16}$ IONS/CM$^2$
EXPOSED SURFACES ONLY

CONTROL
— — — CONTROL W/S.R. ANNEAL
—·—·— IMPLANTED
—··—··— IMPLANTED W/S.R. ANNEAL

(y-axis) WEIGHT GAIN MG/DM$^2$
(x-axis) CORROSION DAYS

**F/G. 6**

ION IMPLANTATION
CHROMIUM
1.4 X 10$^{17}$ IONS/CM$^2$
EXPOSED SURFACES ONLY

WEIGHT GAIN MG / DM$^2$

CORROSION DAYS

——— CONTROL
— — — CONTROL W/S.R. ANNEAL
—·—·— IMPLANTED
—··—··— IMPLANTED W/S.R. ANNEAL

*FIG. 7*

European Patent Office

**EUROPEAN SEARCH REPORT**

| | DOCUMENTS CONSIDERED TO BE RELEVANT | | EP 87300952.6 |
|---|---|---|---|

| Category | Citation of document with indication. where appropriate, of relevant passages | Relevant to claim | CLASSIFICATION OF THE APPLICATION (Int Cl 4) |
|---|---|---|---|
| Y | EP - A1 - 0 166 349 (SUMITOMO ELECTRIC INDUSTRIES LIMITED)<br>* Claims, especially 3 *<br>-- | 1 | C 23 C 14/48<br><br>C 22 C 16/00<br><br>C 23 F 11/00 |
| Y | DE - A - 1 483 211 (EUROPÄISCHE ATOMGEMEINSCHAFT EURATOM)<br>* Claims *<br>-- | 1 | |
| A | DE - A - 2 409 461 (COMMISSARIAT A L'ENERGIE ATOMIQUE)<br>* Claims *<br>-- | 1 | |
| A | US - A - 4 279 667 (T.R.ANTHONY et al.)<br>* Claims *<br>-- | 1,3 | TECHNICAL FIELDS SEARCHED (Int Cl 4) |
| A | US - A - 4 046 659 (R.L.CORMIA et al.)<br>* Claims *<br>---- | 1 | C 23 C<br>C 22 C<br>C 23 F |

The present search report has been drawn up for all claims

| Place of search | Date of completion of the search | Examiner |
|---|---|---|
| VIENNA | 23-04-1987 | SLAMA |

EPO Form 1503 03 82

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document